# EUROPEAN PATENT APPLICATION

(11) **EP 1 033 818 A1**
(43) Date of publication of application: **06.09.2000**
(21) Application number: 98907234.3
(22) Date of filing: 13.03.1998
(51) Int. Cl.: H04B 1/04, H04B 1/40, H03B 21/00

(54) **SIGNAL GENERATING CIRCUIT, AND TRANSMITTER, RECEIVER AND TRANSMITTING AND RECEIVING DEVICE USING THE CIRCUIT**

(30) Priority: 18.11.1997 JP 31731397
(71) Applicant: AIWA CO., LTD., Taito-ku, Tokyo 110-0008 (JP)
(72) Inventor: IBUKI, Takinori, Tokyo 110-0008 (JP)
(74) Representative: Müller, Frithjof E., Dipl.-Ing.
(86) International application number: JP9801082
(87) International publication number: WO9926349

(57) **Abstract**

This invention relates to a signal generation circuit, a transmitter or the like for use with audio devices such as a television receiver and an audio system for transmitting and receiving an outputted audio signal. A frequency-modulation circuit (12) may include a carrier wave signal generation section comprising an oscillation circuit (16) using a vibrator (17). Upon transmission, a switch (19) may be turned on, a frequency-modulated signal of 1200 MHz band may be outputted from the oscillation circuit (16) and this signal may be multiplied twice by a multiplication circuit (13), thereby resulting in a frequency-modulated signal of 2400 MHz band being obtained. This frequency-modulated signal of 2400 MHz band may be supplied to a mixer circuit (15), in which it may be mixed to a frequency signal from a PLL circuit (14). A transmitted high-frequency modulated signal may be extracted by a filter (23), amplified and supplied to an antenna (25). A carrier wave frequency of a high-frequency modulated signal may be adjusted by varying the frequency of the frequency signal from the PLL circuit (14) in a range of from 10 to 20 MHz. Since the frequency stability of the frequency-modulated signal of 2400 MHz band from the multiplication circuit (13) is high and the frequency signal from the PLL circuit (14) has a considerably low frequency, even if the frequency stability of this frequency signal is low, the high-frequency modulated signal may have a high frequency stability.

## Description

### TECHNICAL FIELD

This invention relates to a signal generation for use in transmitting and receiving an outputted audio signal from audio devices such as a television receiver and an audio system, and a transmitter, a receiver and a transceiver sing such signal generator, for example. More specifically, this invention relates to a signal generation circuit or the like in which a signal having a first frequency and a signal having a second frequency which result from multiplying an outputted signal from an oscillation circuit using a vibrator may be mixed to provide a signal having a third frequency so that a signal whose frequency can be varied and whose frequency stability is excellent can be obtained.

### BACKGROUND ART

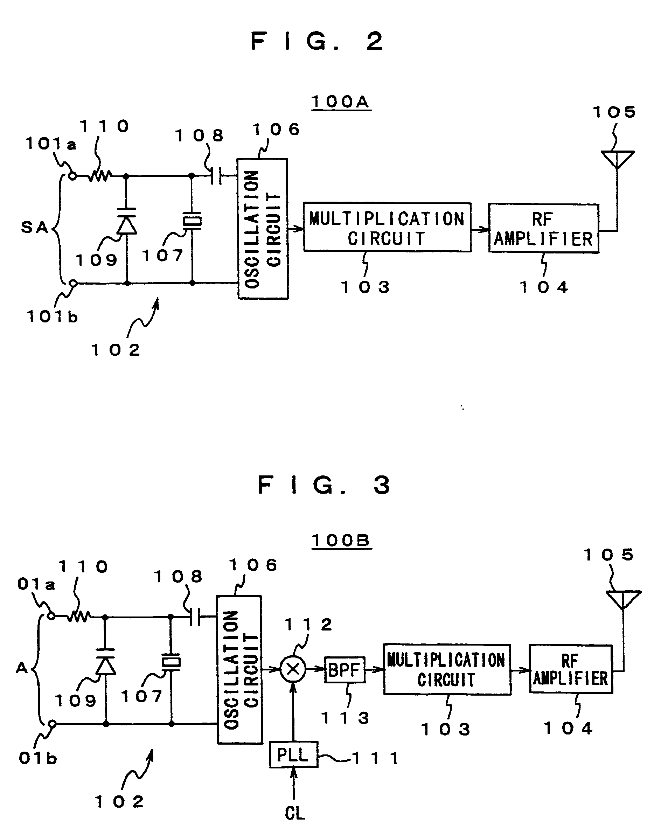

Heretofore, there has been proposed an audio transmission and reception system for transmitting an audio signal to the reception side in the form of frequency-modulated signal. FIG. 2 shows an example of a transmitter comprising the audio transmission and reception system.

This transmitter 100A may include input terminals 101a, 101b to which an audio signal SA may be supplied, a frequency-modulation circuit 102 for frequency-modulating the audio signal SA supplied to the input terminals 101a, 101b, a multiplication circuit 103 for outputting a transmission signal (high-frequency modulated signal) by multiplying the frequency-modulated signal outputted from this frequency-modulation circuit 102 such that its frequency may become an integral multiple, an RF (radio frequency) amplifier 104 for amplifying the transmission signal outputted from this multiplication circuit 103 up to the level at which the transmission signal can be transmitted from a transmission antenna, which will be described later on, and a transmission antenna 105 for transmitting the transmission signal amplified by this RF amplifier 104 to the reception side.

The frequency-modulation circuit 102 may include a carrier wave signal generation section comprising an oscillation circuit 106 using a vibrator. That is, a series circuit of a crystal vibrator 107 and a capacitor 108 may be connected to the oscillation circuit 106. A variable-capacitance diode 109 may be connected in parallel to this crystal vibrator 107, thereby resulting in the frequency-modulation circuit 102 being arranged. Then, the input terminal 101a may be connected through a resistor 110 to the cathode of the diode 109, and the input terminal 101b may be directly connected to the anode of the diode 109.

An operation of the transmitter 100A shown in FIG. 2 will be described. When the audio signal SA is applied between the input terminals 101a, 101b, the capacitance of the diode 109 may be changed in response to the level of this audio signal SA with the result that the oscillation frequency of the oscillation circuit 106 may be changed. Accordingly, this oscillation circuit 106 may output a frequency-modulated signal in which the carrier wave signal is frequency-modulated by the audio signal SA. Then, this frequency-modulated signal may be supplied to the multiplication circuit 103, in which it may be multiplied such that its frequency may become an integral multiple, thereby forming a transmission signal. This transmission signal may be amplified by the RF amplifier 104 and then supplied to the transmission antenna 105, from which the transmission signal is transmitted to the reception side.

FIG. 3 shows another example of the transmitter comprising the audio transmission and reception system. In FIG. 3, elements and parts identical to those of FIG. 2 are marked with the same reference numerals, and therefore need not be described in detail.

This transmitter 100B may include the input terminals 101a, 101b to which the audio signal SA may be supplied, a frequency-modulation circuit 102 for frequency-modulating the audio signal SA supplied between the input terminals 101a 101b, a PLL (phase-locked loop) circuit 111 serving as a frequency-variable type oscillation circuit and a mixer circuit 112 for mixing the frequency-modulated signal outputted from the frequency-modulation circuit 102 and a frequency signal outputted from the PLL circuit 111. A control signal may be supplied to the PLL circuit 111, and the frequency of the frequency signal outputted from the PLL circuit 111 can be varied under control of this control signal CL.

The transmitter 100B may include a band-pass filter 113 for extracting a high-band side signal from an outputted signal of the mixer circuit 112, the multiplication circuit 103 for outputting a transmission signal (high-frequency modulated signal) by multiplying an outputted signal of this filter 113 such that its frequency may become an integral multiple, the RF amplifier 104 for amplifying the transmission signal outputted from this multiplying circuit 103 up to the level at which the transmission signal can be transmitted from a transmission antenna, which will be described later on, and the transmission antenna 105 from which the transmission signal amplified by this RF amplifier 104 may be transmitted to the reception side.

An operation of the transmitter 100B shown in FIG. 3 will be described. When the audio signal SA is supplied between the input terminals 101a, 101b, the capacitance of the diode 109 may be changed in response to the level of this audio signal SA with the result that the oscillation frequency of the oscillation circuit 106 may be changed. Accordingly, this oscillation circuit 106 may output the frequency-modulated signal in which the carrier wave signal was frequency-modulated by the audio signal SA.

This frequency-modulated signal may be supplied to the mixer circuit 112, in which it may be mixed with the frequency signal outputted from the PLL circuit 111. The high band-side signal may be extracted from the outputted signal of the mixer circuit 112 by the band-pass filter 113. Then, the signal extracted by the filter 113 may be supplied to the multiplication circuit 103, in which it may be multiplied in such a manner that its frequency may become an integral multiple, thereby forming a transmission signal. This transmission signal may be amplified by the RF amplifier 104 and supplied to the transmission antenna 105, from which the transmission signal may be transmitted to the reception side.

In this case, it may be possible to vary the carrier wave frequency of the frequency-modulated signal extracted by the filter 113 by varying the frequency of the frequency signal outputted from the PLL circuit 111 under control of the control signal CL. Accordingly, it may become possible to vary the carrier wave frequency of the transmission signal (high-frequency modulated signal) outputted from the multiplication circuit 103.

According to the transmitter 100A shown in FIG. 2, since the frequency-modulation circuit 102 may include the carrier wave signal generation section comprising the oscillation circuit 106 using the crystal vibrator 107, the carrier wave frequency of the frequency-modulated signal outputted from the frequency-modulation circuit 102 may become stable, accordingly, the frequency stability of the transmission signal also may become high. However, there is the disadvantage that this transmitter 100A cannot vary the carrier wave frequency of the transmission signal.

Moreover, according to the transmitter 100B shown in FIG. 3, the carrier wave frequency of the transmission signal can be varied by varying the frequency of the frequency signal outputted from the PLL circuit 111. However, since the PLL circuit is the feedback circuit unlike the oscillation circuit using the crystal vibrator, if the oscillation frequency increases, then a frequency fluctuation may occur in the outputted frequency signal due to a phase shift or the like so that the frequency stability is not satisfactory. Then, this frequency fluctuation may be multiplied by the multiplication circuit 103 to the integral multiple. There is the disadvantage that the transmission signal may have the low frequency stability.

Accordingly, it is an object of this invention to provide a signal generation circuit or the like which can output a signal whose frequency can be varied and whose frequency stability may be excellent.

### DISCLOSURE OF THE INVENTION

A signal generation circuit according to this invention is a signal generation circuit comprising a first signal output means for outputting a signal having a first frequency, a second signal output means for outputting a signal having a second frequency and a frequency-converting means for outputting a signal having a third frequency by mixing the signal having the first frequency and the signal having the second frequency, wherein the first signal output means includes an oscillation circuit using a vibrator and a multiplication circuit for outputting the signal having the first frequency by multiplying an outputted signal from the oscillation circuit.

The signal having the first frequency may be obtained by multiplying the outputted signal from the oscillation circuit using the vibrator such as a crystal, ceramics and SAW (surface acoustic wave) with the multiplication circuit. The signal having the third frequency may be obtained by mixing the signal having the first frequency and the signal having the second frequency.

The signal having the first frequency may be obtained by multiplying the outputted signal from the oscillation circuit using the vibrator), and its frequency may be stable. Therefore, when the second frequency is a frequency lower than the first frequency, even if the frequency stability of the signal having the second frequency is low, it may become possible to obtain a signal having a high-frequency stability as the signal having the third frequency. Also, the second signal output means is comprised of the frequency-variable type oscillation circuit, thereby making it possible to vary the third frequency. A CR oscillation circuit, an LC oscillation circuit, a PLL circuit or the like may be available as the frequency-variable type oscillation circuit.

A transmitter according to this invention comprises a first signal output means for outputting a signal having a first frequency, a second signal output means comprised of an oscillation circuit for outputting a frequency signal having a second frequency and a frequency-conversion means for outputting a high-frequency modulated signal by mixing the signal having the first frequency and the signal having the second frequency, wherein the first signal output means includes a modulation circuit having a carrier wave signal generation circuit comprised of an oscillation circuit using a vibrator and a multiplication circuit for outputting the signal having the first frequency by multiplying an outputted signal from the modulation circuit.

The signal having the first frequency may be obtained by multiplying the frequency-modulated carrier wave signal after the carrier wave signal from the oscillation circuit using the vibrator had been modulated, e.g. frequency-modulated by the transmission signal. The frequency signal having the first frequency and the frequency signal having the second frequency may be mixed to output the high-frequency modulated signal which should be transmitted to the reception side from the antenna, for example.

The signal having the first frequency may be obtained by multiplying the modulated signal obtained after the carrier wave signal from the oscillation circuit using the vibrator had been modulated by the transmission signal, and its frequency may be stable. Therefore, when the second frequency is lower than the first frequency, even if the frequency signal with the second frequency has the low frequency stability, it may become possible to obtain the high-frequency modulated signal having the high-frequency stability. Moreover, the second signal output means is comprised of the frequency-variable type oscillation circuit, thereby making it possible to vary the frequency of the carrier wave signal of the high-frequency modulated signal.

A receiver according to this invention comprises a first signal output means for outputting a frequency signal having a first frequency, a second signal output means comprising an oscillation circuit for outputting a frequency signal having a second frequency, a first frequency-conversion means for outputting a frequency signal having a third frequency by mixing the frequency signal having the first frequency and the frequency signal having the second frequency and a second frequency-conversion means for outputting an intermediate-frequency signal by mixing a received high-frequency signal and the frequency signal having the third frequency, wherein the first signal output means includes an oscillation circuit using a vibrator and a multiplication circuit for outputting the frequency signal having the first frequency by multiplying an outputted signal from the oscillation circuit.

The signal having the first frequency may be obtained by multiplying the outputted signal from the oscillation circuit using the vibrator with the multiplication circuit. The frequency signal having the third frequency may be obtained by mixing the frequency signal having the first frequency and the frequency signal having the second frequency. Moreover, the intermediate-frequency signal may be obtained by mixing the received high-frequency signal and the frequency signal having the third frequency. Then, there can be obtained the reception signal by demodulating and detecting this intermediate-frequency signal.

The frequency signal having the first frequency may be obtained by multiplying the outputted signal from the oscillation circuit using the vibrator, and its frequency may be stable. Therefore, when the second frequency is lower than the first frequency, even if the frequency signal having the second frequency has the low frequency stability, it may become possible to obtain the frequency signal having the third frequency whose frequency stability is high. Moreover, since the second signal output means is comprised of the frequency-variable type oscillation circuit, the frequency of the frequency signal having the third frequency can be varied in response to the carrier wave frequency of the received high-frequency signal, thereby making it become possible to convert the received high-frequency signal into the intermediate-frequency signal with ease.

A transceiver according to this invention comprises a first signal output means for outputting a signal having a first frequency, a second signal output means comprising an oscillation circuit for outputting a frequency signal having a second frequency and a frequency-conversion means for outputting a signal having a third frequency by mixing the signal having the first frequency and the frequency signal having the second frequency, wherein the first signal output means includes a modulation circuit having a carrier wave signal generation section comprising an oscillation circuit using a vibrator and a multiplication circuit for outputting the signal having the first frequency by multiplying an outputted signal from the modulation circuit. Upon transmission, the modulation circuit in the first signal output means outputs a modulated signal and the frequency-conversion means outputs a high-frequency modulated signal as the signal having the third frequency. Upon reception, the modulation circuit in the first signal output means outputs a carrier wave signal and the frequency-conversion means outputs a frequency signal used to convert a received high-frequency signal into an intermediate-frequency signal as the signal having the third frequency.

The signal having the first frequency may be obtained by multiplying the outputted signal from the modulation circuit including the carrier wave signal generation circuit using the vibrator with the multiplication circuit. The signal having the third frequency may be obtained by mixing the signal having the first frequency and the frequency signal having the second frequency. Upon transmission, the modulation circuit may output the modulated signal in which the carrier wave signal is modulated by the transmission signal. As the signal having the third frequency, there may be obtained the high-frequency modulated signal that should be transmitted to the reception side from the antenna, for example. Upon reception, the carrier wave signal may be outputted from the modulation circuit, and the frequency signal for frequency-conversion may be obtained as the signal having the third frequency. The intermediate-frequency signal may be obtained by mixing this frequency signal and the received high-frequency signal. Further, the reception signal may be obtained by demodulating and detecting this intermediate-frequency signal.

The modulation circuit may include the carrier wave signal generation section using the vibrator. Therefore, upon transmission, the frequency of the modulated signal outputted from the modulation circuit may be stable. When the second frequency is lower than the first frequency, even if the frequency stability of the frequency signal having the second frequency is low, it may become possible to obtain the high-frequency modulated signal in which the stability of the carrier wave frequency is high. Moreover, the second signal output means is comprised of the frequency-variable type oscillation circuit, thereby making it become possible to vary the carrier wave frequency of the high-frequency modulated signal.

Upon reception, the frequency of the carrier wave signal outputted from the modulation circuit may be stable. When the second frequency is lower than the first frequency, even if the frequency stability of the frequency signal having the second frequency is low, it may become possible to obtain the frequency signal having the excellent frequency stability as the frequency signal for frequency-conversion. Moreover, since the second signal output means is comprised of the frequency-variable type oscillation circuit, it may become possible to vary the frequency of the frequency-conversion frequency signal in response to the carrier wave frequency of the received high-frequency signal. That is, it may become possible to vary the frequency of the frequency-conversion frequency signal in such a manner that the carrier wave frequency of the intermediate-frequency signal may become a predetermined value.

Upon reception, the oscillation frequency of the oscillation circuit comprising the second signal output section may be shifted by a frequency equal to the carrier wave frequency of the intermediate-frequency signal as compared with the transmission mode. Thus, when the received high-frequency signal is a signal similar to the high-frequency modulated signal transmitted to the reception side upon transmission, it may become possible to constantly obtain the intermediate-frequency signal by using the above-mentioned frequency-conversion frequency signal.

### BRIEF DESCRIPTION OF DRAWINGS

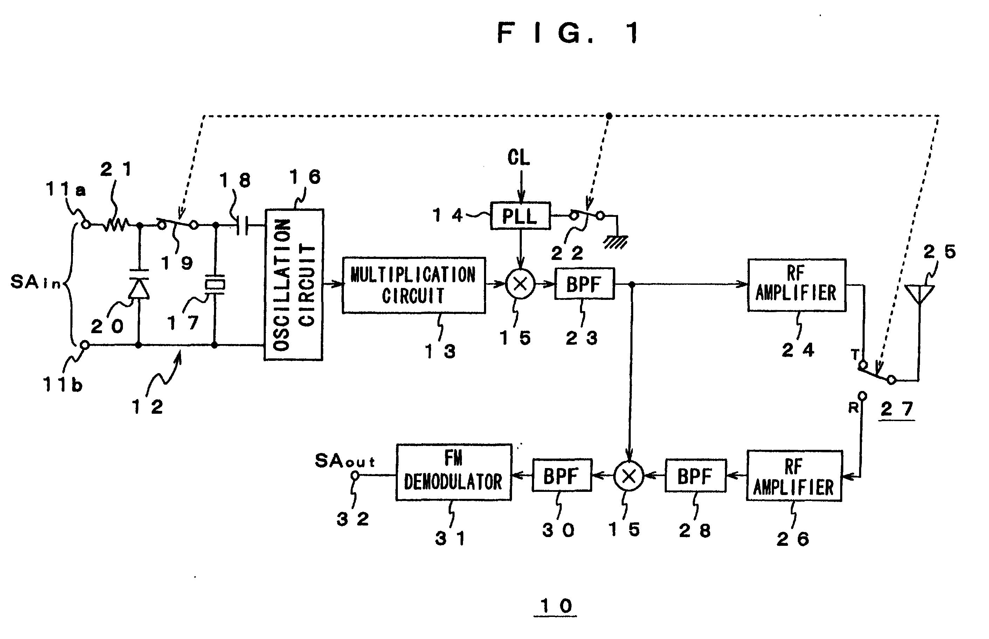

FIG. 1 is a block diagram showing a transceiver comprising an audio transmission and reception system according to the best mode of this invention. FIG. 2 is a block diagram showing a transmitter comprising a prior-art audio transmission and reception system. FIG. 3 is a block diagram showing a transmitter comprising the prior-art audio transmission and reception system.

### BEST MODE FOR CARRYING OUT THE INVENTION

FIG. 1 shows a transceiver 10 comprising an audio transmission and reception system according to the best mode of this invention. This transceiver 10 may use a frequency-modulated signal of 2400 MHz band in order to transmit an audio signal.

The transceiver 10 may comprise input terminals 11a, 11b to which an audio signal SAin may be supplied, a frequency-modulation circuit 12 for frequency-modulating the audio signal SAin supplied between the input terminals 11a, 11b, a multiplication circuit 13 for multiplying the outputted signal of this frequency-modulation circuit 12 such that its frequency may become twice, a PLL circuit 14 serving as a frequency-variable type oscillation circuit and a mixer circuit 15 serving as a frequency-conversion means for mixing the outputted signal from the multiplication circuit 13 and a frequency signal outputted from the PLL circuit 14.

The frequency-modulation circuit 12 may include a carrier wave signal generation section comprising an oscillation circuit 16 using a vibrator. That is, a series circuit of a crystal vibrator 17 and a capacitor 18 may be connected to the oscillation circuit 16, and a series circuit of a connection switch 19 and a variable-capacitance diode 20 may be connected to this crystal vibrator 17, thereby resulting in the frequency-modulation circuit 12 being arranged. Then, the input terminal 11a may be connected through a resistor 21 to the cathode of the diode 20, and the input terminal 11b may be directly connected to the anode of the diode 20.

In this case, the frequency of the carrier wave signal generated from the oscillation circuit 16 may be set to the frequency of 1200 MHz band. Then, the connection switch 19 may be turned on upon transmission, and may be turned off upon reception. Thus, while the oscillation circuit 16 may output a frequency- modulated signal in which the carrier wave signal is frequency-modulated by the audio signal SAin upon transmission, the oscillation circuit 16 may output the carrier wave signal itself upon reception.

The PLL circuit 14 may be supplied with a control signal CL for controlling the frequency of the outputted frequency signal, and may be connected with a connection switch 22. The connection switch 22 may be adapted to determine whether or not the frequency of the frequency signal outputted from the PLL circuit 14 should be shifted by 10.7 MHz (10.7 MHz is a carrier wave signal of an intermediate-frequency signal). This connection switch may be turned on upon transmission, and may be turned off upon reception. Thus, the PLL circuit 14 may output a frequency signal which changes in a range of from 10 to 20 MHz upon transmission, and may output a frequency signal which changes in a range of from (10 + 10.7) to (20 + 10.7) MHz upon reception.

Also, the transceiver 10 may include a band-pass filter 23 for extracting a high-band side signal from the outputted signal of the mixer circuit 15, an RF amplifier 24 for amplifying the outputted signal of this filter 23 up to the level at which this outputted signal can be transmitted from a transmission and reception antenna, which will be described later on, a transmission and reception antenna 25, an RF amplifier 26 for amplifying a high-frequency signal received at this antenna 25 up to the level at which this high-frequency signal can be processed at the later stage and a change-over switch 27 for supplying the signal amplified by the RF amplifier 24 to the antenna 25 upon transmission and supplying the high-frequency signal received at the antenna 25 to the RF amplifier 26 upon reception.

In this case, a T-side fixed contact of the change-over switch 27 may be connected to the output side of the RF amplifier 24, and its R-side fixed contact may be connected to the input side of the RF amplifier 26. Further, its movable contact may be connected to the antenna 25. Then, the change-over switch 27 may be connected to the T-side upon transmission, and may be connected to the R-side upon reception.

Moreover, the transceiver 10 may include a band-pass filter 28 for limiting the band of the high-frequency signal amplified by the RF amplifier 26, a mixer circuit 29 serving as the frequency-conversion means for mixing the outputted signal from the above-mentioned band-pass filter 23 and the outputted signal from the band-pass filter 28, a band-pass filter 30 having a center frequency of 10.7 MHz to extract the intermediate-frequency signal from the outputted signal of this mixer 29, an FM-demodulator 31 for demodulating and detecting an intermediate-frequency signal (frequency-modulation signal) outputted from this band-pass filter 30 to provide an audio signal Saout and an output terminal 32 at which the audio signal Saout outputted from this FM-demodulator 31 may be developed.

An operation of the transceiver 10 shown in FIG. 1 will be described next. Initially, the manner in which the transceiver is operated upon transmission will be described. Upon transmission, the connection switches 19, 22 may be turned on and the change-over switch 27 may be connected to the T-side.

When the audio signal SAin is supplied between the input terminals 11a, 11b, the capacitance of the diode 20 may be changed in response to the level of this audio signal SAin with the result that the oscillation frequency of the oscillation circuit 16 may be changed. Therefore, this oscillation circuit 16 may output a frequency-modulated signal of 1200 MHz band in which the carrier wave signal of 1200 MHz band was frequency-modulated by the audio signal SAin. This frequency-modulated signal may be multiplied twice by the multiplication circuit 13 and thereby convened into a frequency-modulated signal of 2400 MHz band.

The frequency-modulated signal of 2400 MHz band outputted from the multiplication circuit 13 may be supplied to the mixer circuit 15, in which it is mixed with the frequency signal outputted from the PLL circuit 14. The band-pass filter 23 may extract the high-band side signal from the outputted signal of this mixer circuit 15. Then, the frequency-modulated signal of 2400 MHz band extracted by this band-pass filter 23 may be amplified by the RF amplifier 24, whereafter it may be supplied through the T-side of the change-over switch 27 to the transmission and reception antenna 25 from which it may be transmitted to the reception side. In this case, by changing the frequency of the frequency signal outputted from the PLL circuit 14 in a range of from 10 to 20 MHz under control of the control signal CL, it may become possible to adjust the carrier wave frequency of the transmitted frequency-modulated signal.

The manner in which this transceiver is operated upon reception will be described next. Upon reception, the connection switches 19, 22 may be turned off, respectively, and the change-over switch 27 may be connected to the R-side. Since the connection switch 19 may be turned off, the oscillation circuit 16 may output the carrier wave signal of 1200 MHz band as it is. That carrier wave signal may be multiplied twice by the multiplication circuit 13 and thereby converted into the frequency signal of 2400 MHz band. The frequency signal of 2400 MHz band and the frequency signal outputted from the PLL circuit 14 may be supplied to and mixed by the mixer circuit 15. Then, the band-pass filter 23 may extract the high-band side signal from the outputted signal of the mixer circuit 15. This high-band side signal may be used as a frequency-conversion frequency signal as will be described later on.

Moreover, upon reception, the frequency-modulated signal of 2400 MHz band serving as the high-frequency signal received at the transmission and reception antenna 25 may be supplied through the R-side of the change-over switch 27 to the RF amplifier 26 and thereby amplified, whereafter it may be supplied through the band-pass filter 28 to the mixer circuit 29. The mixer circuit 29 may mix the received frequency-modulated signal of 2400 MHz band and the frequency conversion frequency signal extracted by the band-pass filter 23. Then, the band-pass filter 30 may extract the intermediate-frequency signal in which the carrier wave signal is 10.7 MHz from the outputted signal of the mixer circuit 29. Then, this intermediate-frequency signal may be demodulated by the FM-demodulator 31 and thereby the audio signal Saout may be developed at an output terminal 32.

In this case, since the connection switch 22 is turned off, the frequency signal outputted from the PLL circuit 14 may be shifted to the high-band side by 10.7 MHz as compared with the transmission mode. Therefore, when the received frequency-modulated signal of 2400 MHz band is obtained by the transmission system substantially equal to the transmission system of the transceiver 10 shown in FIG. 1, it may become possible to constantly obtain the intermediate-frequency signal by using the frequency conversion frequency signal extracted by the band-pass filter 23.

As set forth above, according to this embodiment, the frequency-modulation circuit 12 may include the carrier wave signal generation section comprising the oscillation circuit 16 using the crystal vibrator 17. Therefore, upon transmission, the frequency-modulated signal of 2400 MHz band outputted from the oscillation circuit 16, accordingly, the frequency-modulated signal of 2400 MHz band outputted from the multiplication circuit 13 may have the stable frequency. Then, since the frequency signal outputted from the PLL circuit 14 may change in a range of from 10 to 20 MHz and may have a considerably low frequency as compared with the frequency-modulated signal of 2400 MHz band outputted from the multiplication circuit 13, there is then the advantage that, even when the frequency stability of this frequency signal is low, the frequency stability of the frequency-modulated signal of 2400 MHz band extracted from the band-pass filter 23 and transmitted to the reception side may become high. In addition, by controlling the frequency of the frequency signal outputted from the PLL circuit 14 based on the control signal CL, it may be possible to adjust the carrier wave frequency of the frequency-modulated signal of 2400 MHz band serving as the transmission signal.

Upon reception, the carrier wave signal of 1200 MHz band outputted from the oscillation circuit 16, accordingly, the frequency of the frequency signal of 2400 MHz band outputted from the multiplication circuit 13 may be stable. Then, since the frequency signal outputted from the PLL circuit 14 may change in a range of from (10 + 10.7 MHz) to (20 + 10.7) MHz and may have a considerably low frequency as compared with the frequency signal of 2400 MHz band outputted from the multiplication circuit 13, even when the frequency stability of this frequency signal is low, the frequency stability of the frequency signal of 2400 MHz band extracted by the band-pass filter 23 may become high. As a consequence, the received high-frequency signal can be satisfactorily converted into the intermediate-frequency signal by using such frequency signal. In addition, by varying the frequency of the frequency signal outputted from the PLL circuit 14 based on the control signal CL, the frequency of the frequency conversion frequency signal outputted from the band-pass filter 23 can be changed in response to the carrier wave frequency of the received high-frequency signal, thereby making it possible to convert the received high-frequency signal into the intermediate-frequency signal with ease.

While the modulation system in which the audio signal is frequency-modulated and transmitted has been described so far as described above, the modulation system is not limited thereto, and the present invention can be applied to the system in which the audio signal, for example, is amplitude-modulated and then transmitted. Moreover, while the frequency values have been described so far by way of example in the above-mentioned embodiment, it is needless to say that the frequency values may not be limited to the above-mentioned value. Furthermore, while the PLL circuit 14 has been used as the frequency-variable type oscillation circuit as described in the above-mentioned embodiment, the present invention is not limited thereto, and simple CR oscillation circuit, LC oscillation circuit and the like may be used as the frequency-variable type oscillation circuit.

### INDUSTRIAL APPLICABILITY

As described above, the signal generation circuit and the transmitter, the receiver and the transceiver using such signal generation circuit according to this invention are suitable for use with audio transmission apparatus such as a television receiver and an audio system for transmitting and receiving an outputted audio signal via radio waves.

## Claims

1. A signal generation circuit comprising:
a first signal output means for outputting a signal having a first frequency;
a second signal output means for outputting a signal having a second frequency; and
a frequency-conversion means for outputting a signal having a third frequency by mixing said signal having the first frequency and said signal having the second frequency, wherein said first signal output means includes an oscillation circuit using a vibrator and a multiplication circuit for outputting said signal having the first frequency by multiplying an outputted signal from said oscillation circuit.

2. A signal generation circuit as claimed in claim 1, wherein said second signal output means comprises a frequency-variable type oscillation circuit.

3. A signal generation circuit as claimed in claim 1, wherein said second frequency is lower than said first frequency.

4. A transmitter comprising:
a first signal output means for outputting a signal having a first frequency;
a second signal output means comprised of an oscillation circuit for outputting a signal having a second frequency; and
a frequency-conversion means for outputting a high-frequency modulation signal by mixing said signal having the first frequency and said signal having the second frequency, wherein said first signal output means includes a modulation circuit having a carrier wave signal generation circuit comprised of an oscillation circuit using a vibrator and a multiplication circuit for outputting said signal having the first frequency by multiplying an outputted signal from said modulation circuit.

5. A transmitter as claimed in claim 4, wherein said oscillation circuit comprising said second signal output means is a frequency-variable type oscillation circuit.

6. A transmitter as claimed in claim 4, wherein said second frequency is lower than said first frequency.

7. A receiver comprising:
a first signal output means for outputting a frequency signal having a first frequency;
a second signal output means comprising an oscillation circuit for outputting a frequency signal having a second frequency;
a first frequency-conversion means for outputting a frequency signal having a third frequency by mixing said frequency signal having a first frequency and said frequency signal having a second frequency; and
a second frequency-conversion means for outputting an intermediate-frequency signal by mixing a received high-frequency signal and said frequency signal having a third frequency, wherein said first signal output means includes an oscillation circuit using a vibrator and a multiplication circuit for outputting said frequency signal having a first frequency by multiplying an outputted signal from said oscillation circuit.

8. A receiver as claimed in claim 7, wherein said oscillation circuit comprising said second signal output means is a frequency-variable type oscillation circuit.

9. A receiver as claimed in claim 7, wherein said second frequency is lower than said first frequency.

10. A transceiver comprising:
a first signal output means for outputting a signal having a first frequency;
a second signal output means comprising an oscillation circuit for outputting a frequency signal having a second frequency; and
a frequency-conversion means for outputting a signal having a third frequency by mixing said signal having the first frequency and said frequency signal having a second frequency, wherein said first signal output means includes a modulation circuit having a carrier wave signal generation section comprising an oscillation circuit using a vibrator and a multiplication circuit for outputting said signal having the first frequency by multiplying an outputted signal from said modulation circuit, upon transmission, said modulation circuit in said first signal output means outputs a modulated signal and said frequency-conversion means outputs a high-frequency modulated signal as said signal having the third frequency and upon reception, said modulation circuit in said first signal output means outputs a carrier wave signal and said frequency-conversion means outputs a frequency signal used to convert a high-frequency signal received as said signal having the third frequency into an intermediate-frequency signal.

11. A transceiver as claimed in claim 10, wherein said oscillation circuit comprising said second signal output means is a frequency-variable type oscillation circuit.

12. A transceiver as claimed in claim 10, wherein said second frequency is lower than said first frequency.

13. A transceiver as claimed in claim 10, wherein upon reception the oscillation frequency of said oscillation circuit comprising said second signal output means is shifted by a frequency equal to the carrier wave frequency of said intermediate-frequency signal as compared with the transmission mode.
